# EUROPEAN PATENT APPLICATION

(11) **EP 1 653 783 A1**
(43) Date of publication of application: **03.05.2006**
(21) Application number: 03817649.1
(22) Date of filing: 28.07.2003
(51) Int. Cl.: H05B 33/12, H05B 33/14, H05B 33/22, C09K 11/06

(54) **WHITE ORGANIC ELECTROLUMINESCENCE ELEMENT**

(71) Applicant: IDEMITSU KOSAN CO., LTD., Tokyo 100-8321 (JP)
(72) Inventor: FUKUOKA, Kenichi, Sodegaura-shi, Chiba 299-0293 (JP); HOSOKAWA, Chishio, Sodegaura-shi, Chiba 299-0293 (JP)
(74) Representative: Gille Hrabal Struck Neidlein Prop Roos
(86) International application number: PCT/JP2003/009525
(87) International publication number: WO 2005/011333

(57) **Abstract**

A white electroluminescent device (1) including in sequence: an anode (2), a blue emitting layer (5) containing a host material and a blue dopant, a yellow-to-red emitting layer (6) containing a host material identical to the host material of the blue emitting layer and a yellow-to-red dopant, and a cathode (8), the blue emitting layer (5) and the yellow-to-red emitting layer (6) forming an emitting layer. The tendency for red to be strong in emitted light can be negated by using a blue emitting layer (5) as an emitting layer on the anode (2) side, the emission range of which tends to be offset in the type where an emitting layer is divided into two layers. Consequently, the thickness of the yellow-to-red emitting layer (6) can be greater, leading to a small chromaticity change.

## Description

### Technical Field

The invention relates to a white organic electroluminescent device ("electroluminescent" is abbreviated as EL hereinafter).

### Background Art

In recent years, white organic EL devices have been developed actively because they are usable for a mono-color display device, lighting such as backlighting, a full-color display device using a color filter and so on.

Chromaticity change in a white organic EL device degrades its quality as a product, and furthermore it causes poor color reproducibility, for example, in a full-color display combined with a color filter. A white organic EL device with a small chromaticity change is thus desired.

There have been disclosed a number of methods to achieve white emission using organic EL materials. Few of the methods produce a white color using only one kind of emitting material; usually 2 to 3 kinds of emitting materials emit at the same time in single organic EL device.

In case where three kinds of emitting materials are used, the combination of red, blue and green emission, which corresponds to the three primary colors, produce a white color. However, there is a problem that chromaticity control is difficult and the reproducibility is poor.

In case where two kinds of emitting materials are used, a blue emitting material and a yellow-to-red light emitting material, yellow-to-red being the complementary color of blue, are selected. However, the emission of yellow-to-red is often intensified to easily cause a change in color.

In conventional white organic EL devices, for example, as shown in Reference Examples 1 and 2 of JP-A-2001-52870, blue light tends to easily weaken with a color change.

A white emission can also be obtained by doping with a blue dopant and a yellow-to-red dopant at the same time and adjusting their doping ratio. However red trends to intensify and, furthermore, energy easily transfers from blue to red, thereby yielding a white color tinged with red. In order to obtain a white color, it is necessary to use a yellow-to-red dopant at a very low concentration and reproducibility is therefore difficult to achieve.

There is a method in which a yellow-to-red material is doped into a hole-transporting layer adjacent to an emitting layer. In this method, since it is difficult to inject electrons into the hole-transporting layer, there is not strong red-shift for the emission in this device structure even though yellow-to-red dopant is used. Therefore, it is easy to balance blue emission and yellow-to-red emission to attain white emission. The method has an excellent luminous efficiency and long lifetime.

However, it has a serious problem in that the chromaticity change is large after continuously driving or storage at high temperatures, which problem is caused by the distance dependency of energy transportation.

The inventors have found that the reason for chromaticity change is probably as follows: excited molecules for red emission are concentrated in an interface on the hole-transporting layer side. Balance between electrons and holes is lost by degeneration. Consequently even a small change in degree of concentration in the interface causes a large change in red emission but no large change in blue emission.

There is a type of a white device with two stacked emitting layers which are a yellow-to-red emitting layer on the anode side and a blue emitting layer on the cathode side.

This type is excellent in efficiency. However, in order to obtain a white color, the thickness of the yellow-to-red emitting layer must be thinner than that of the blue emitting layer, or the concentration of a dopant in the yellow-to-red emitting layer must be smaller than that in the blue emitting layer to suppress yellow-to-red emission. Consequently fabricating the device is difficult.

In particular the thickness of the yellow-to-red emitting layer is often required to be about 1 to 2 nm for white emission. This thickness is as thin as the molecule size of ordinary low molecule type organic EL materials and controlling the thickness is thus extremely difficult.

In light of the above-mentioned problems, an object of the invention is to provide a white organic EL device with reduced chromaticity changes.

### Disclosure of the Invention

Through research for solving the foregoing problems, the inventors found that the tendency for red to be strong in emitted light can be negated by using a blue emitting layer as an emitting layer on the anode side, the emission range of which tends to be offset in the type where an emitting layer is divided into two layers, and completed the invention.

According to the invention, there are provided the following white organic EL devices.
[1] A white electroluminescent device comprising in sequence:
   an anode,
   a blue emitting layer containing a host material and a blue dopant,
   a yellow-to-red emitting layer containing a host material identical to the host material of the blue emitting layer and a yellow-to-red dopant, and
   a cathode,
   the blue emitting layer and the yellow-to-red emitting layer forming an emitting layer.
[2] A white electroluminescent device according to [1], wherein the blue emitting layer comprises an oxidizer.
[3] A white electroluminescent device according to [1], further comprising a first organic layer between the anode and the blue emitting layer, the first organic layer comprising an oxidizer.
[4] A white electroluminescent device according to any one of [1] to [3], wherein the yellow-to-red emitting layer comprises a reducer.
[5] A white electroluminescent device according to any one of [1] to [3], further comprising a second organic layer between the cathode and the yellow-to-red emitting layer and the second organic layer comprises a reducer.
[6] A white electroluminescent device according to any one of [1] to [5], further comprising an inorganic compound layer contacting the anode and/or the cathode.
[7] A white electroluminescent device according to any one of [1] to [6], wherein the host material is a styryl derivative, an anthracene derivative or an aromatic amine.
[8] A white electroluminescent device according to [7], wherein the styryl derivative is a di-styryl derivative, a tris-styryl derivative, a tetra-styryl derivative or a styryl amine derivative.
[9] A white electroluminescent device according to [7], wherein the anthracene derivative is a compound containing a phenyl anthracene skeleton.
[10] A white electroluminescent device according to [7], wherein the aromatic amine is a compound containing 2, 3 or 4 nitrogen atoms substituted with an aromatic group.
[11] A white electroluminescent device according to [10], wherein the aromatic amine further contains at least one alkenyl group.
[12] A white electroluminescent device according to any one of [1] to [11], wherein the blue dopant is at least one compound selected from styryl amines, amine substituted styryl compounds and fused-aromatic-ring containing compounds.
[13] A white electroluminescent device according to any one of [1] to [12], wherein the yellow-to-red dopant is a compound containing a plurality of fluoranthene skeletons.
[14] A white electroluminescent device according to any one of [1] to [13], wherein the yellow-to-red dopant is a compound containing an electron-donating group and a fluoranthene skeleton.
[15] A white electroluminescent device according to any one of [1] to [14], wherein a fluorescence peak wavelength of the yellow-to-red dopant is 540 nm to 700 nm.
[16] A white electroluminescent device according to any one of [1] to [15], wherein the thickness of the blue emitting layer or the yellow-to-red emitting layer is 5 nm and more.

### Brief Description of the Drawings

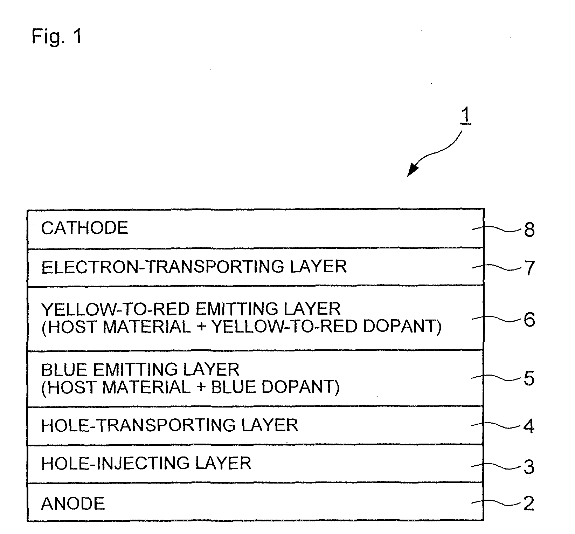

Fig. 1 is a view showing a white organic EL device according to an embodiment of the invention.

### Best Modes for Carrying Out the Invention

In the invention, an anode, a blue emitting layer, a yellow-to-red emitting layer and a cathode are sequentially stacked. An emitting layer is formed of the two layers, the blue emitting layer and the yellow-to-red emitting layer. The blue emitting layer is on the anode side and the yellow-to-red emitting layer is on the cathode side. The blue and yellow-to-red emitting layers both contain the same host material.

Another layer can be interposed between the blue emitting layer and the yellow-to-red emitting layer. Another organic layer or inorganic layer can be interposed between the anode and the blue emitting layer, or the yellow-to-red emitting layer and the cathode.

The materials of the interposed layers are not limited as long as they can transport electrons or holes and they are translucent. Preferred examples include In oxides, Sn oxides, Zn oxides, Zn sulfides, Cd sulfides and Ga nitrides.

The following exemplifies the structure of white organic EL devices of the invention.
Anode/blue emitting layer/yellow-to-red emitting
layer/cathode
Anode/hole-transporting layer/blue emitting
layer/yellow-to-red emitting layer/cathode
Anode/blue emitting layer/ yellow-to-red emitting
layer/electron-transporting layer/cathode
Anode/hole-transporting layer/blue emitting
layer/yellow-to-red emitting layer/electron-transporting
layer/cathode
Anode/hole-injecting layer/hole-transporting layer/blue
emitting layer/yellow-to-red emitting
layer/electron-transporting layer/cathode
Anode/hole-injecting layer/hole-transporting layer/blue
emitting layer/yellow-to-red emitting
layer/electron-transporting layer/electron-injecting
layer/cathode
Structures other than the above are also possible so long as the blue emitting layer is closer to the anode than the yellow-to-red emitting layer.

Fig.1 is a view showing a white organic EL device of an embodiment of the invention.

A white organic EL device 1 is of a multilayer structure comprising an anode 2, hole-injecting layer(first organic layer) 3, hole -transporting layer 4, blue emitting layer 5, yellow-to-red emitting layer 6, electron-transporting layer(second organic layer) 7 and cathode 8.

In the white organic EL device 1, the emitting layer is constituted of only two layers, i.e., the stacked blue emitting layer 5 and yellow-to-red emitting layer 6.

In a white organic EL device of the invention, the tendency of red emission being enhanced can be reduced, since a blue emitting layer is on the anode side. Therefore, in order to obtain white emission without red-shift, it is not necessary to make the thickness of the yellow-to-red emitting layer thinner or reduce the doping concentration of the yellow-to-red emitting layer compared to that of blue emitting layer. Consequently, the thickness of the yellow-to-red emitting layer can be made greater than heretofore, leading to a small chromaticity change.

Since the host materials of the blue emitting layer and yellow-to-red emitting layer are the same, the light emission of the blue emitting layer does not concentrate in the interface and it is hardly affected by variations in the interface.

The thickness of the yellow-to-red emitting layer is great enough not to be affected by interface variations.

Consequently, the white organic EL device of the invention has smaller color changes of the emission than heretofore, even in high temperature environments or continuous driving conditions. It is suitably used for information displays, displays for automobiles, lighting devices and the like.

A blue emitting layer and a yellow emitting layer, characteristic parts of the invention, will be mainly described below. The structures and fabrication of other organic layers, inorganic compound layers, anodes, cathodes and so on will be described briefly since they can have general structures.

### 1. Emitting layers

### (1) Blue emitting layer

The blue emitting layer comprises a host material and a blue dopant.

The host material is preferably a styryl derivative, anthracene derivative or aromatic amine.

The styryl derivative is further preferably at least one selected from distyryl derivatives, tristyryl derivatives, tetrastyryl derivatives and styrylamine derivatives.

The anthrancene derivative is particularly preferably a compound that contains a phenylanthrancene skeleton.

The aromatic amine is preferably a compound containing 2 to 4 nitrogen atoms substituted with an aromatic group. Particularly preferred are a compound containing 2 to 4 nitrogen atoms substituted with an aromatic group and at least one alkenyl group.

Examples of the above styryl derivatives and anthrancene derivatives are compounds represented by the following general formulas [1] to [5] and the above aromatic amines are compounds represented by the following general formulas [6] to [7]. 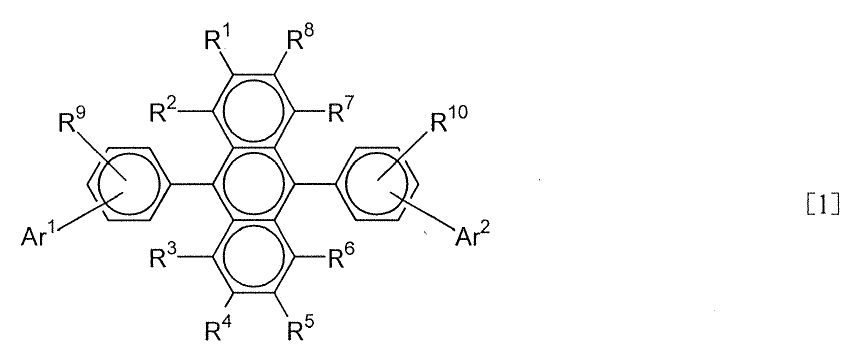 wherein R¹ to R¹⁰ are independently a hydrogen atom, a halogen atom, a cyano group, a nitro group, a substituted or unsubstituted alkyl group with 1 to 20 carbon atoms, a substituted or unsubstituted alkoxy group with 1 to 20 carbon atoms, a substituted or unsubstituted aryloxy group with 6 to 30 carbon atoms, a substituted or unsubstituted alkylthio group with 1 to 20 carbon atoms, a substituted or unsubstituted arylthio group with 6 to 30 carbon atoms, an substituted or unsubstituted arylalkyl group with 7 to 30 carbon atoms, an unsubstituted monocyclic group with 5 to 30 carbon atoms, a substituted or unsubstituted condensed polycyclic group with 10 to 30 carbon atoms or a substituted or unsubstituted hetrocyclic group with 5 to 30 carbon atoms; Ar¹ and Ar² are independently a substituted or unsubstituted aryl group with 6 to 30 carbon atoms or a substituted or unsubstituted alkenyl group; and the substitutent is a substituted or unsubstituted alkyl group with 1 to 20 carbon atoms, a substituted or unsubstituted alkoxy group with 1 to 20 carbon atoms, a substituted or unsubstituted aryloxy group with 6 to 30 carbon atoms, a substituted or unsubstituted alkylthio group with 1 to 20 carbon atoms, a substituted or unsubstituted arylthio group with 6 to 30 carbon atoms, a substituted or unsubstituted arylalkyl group with 6 to 30 carbon atoms, an unsubstituted monocyclic group with 5 to 30 carbon atoms, a substituted or unsubstituted condensed polycyclic group with 10 to 30 carbon atoms or a substituted or unsubstituted heterocyclic group with 5 to 30 carbon atoms. 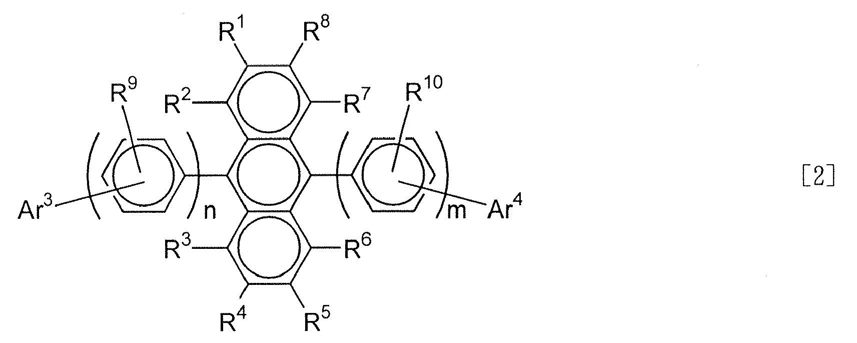 wherein R¹ to R¹⁰ are independently a hydrogen atom, a halogen atom, a cyano group, a nitro group, a substituted or unsubstituted alkyl group with 1 to 20 carbon atoms, a substituted or unsubstituted alkoxy group with 1 to 20 carbon atoms, a substituted or unsubstituted aryloxy group with 6 to 30 carbon atoms, a substituted or unsubstituted alkylthio group with 1 to 20 carbon atoms, a substituted or unsubstituted arylthio group with 6 to 30 carbon atoms, an substituted or unsubstituted arylalkyl group with 7 to 30 carbon atoms, an unsubstituted monocyclic group with 5 to 30 carbon atoms, a substituted or unsubstituted condensed polycyclic group with 10 to 30 carbon atoms or a substituted or unsubstituted hetrocyclic group with 5 to 30 carbon atoms; Ar³ and Ar⁴ are independently a substituted or unsubstituted aryl group with 6 to 30 carbon atoms or a substituted or unsubstituted alkenyl group; the substitutent is a substituted or unsubstituted alkyl group with 1 to 20 carbon atoms, a substituted or unsubstituted alkoxy group with 1 to 20 carbon atoms, a substituted or unsubstituted aryloxy group with 6 to 30 carbon atoms, a substituted or unsubstituted alkylthio group with 1 to 20 carbon atoms, a substituted or unsubstituted arylthio group with 6 to 30 carbon atoms, a substituted or unsubstituted arylalkyl group with 6 to 30 carbon atoms, an unsubstituted monocyclic group with 5 to 30 carbon atoms, a substituted or unsubstituted condensed polycyclic group with 10 to 30 carbon atoms, a substituted or unsubstituted heterocyclic group with 5 to 30 carbon atoms or a substituted or unsubstituted alkenyl group with 4 to 40 carbon atoms; n is 1 to 3, m is 1 to 3 and n+m is 2 or more. 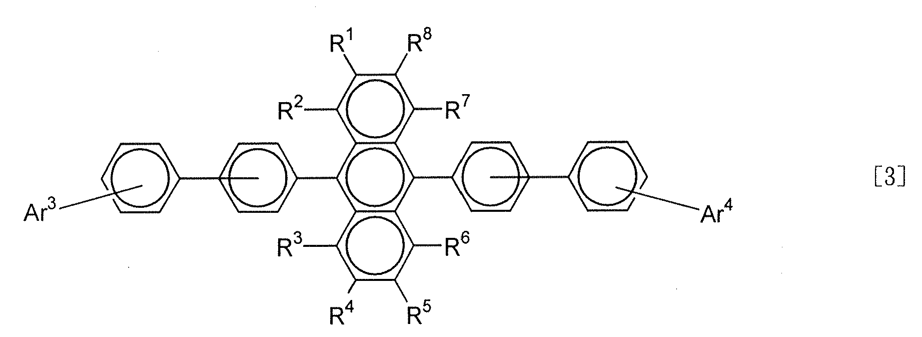 wherein R¹ to R⁸ are independently a hydrogen atom, a halogen atom, a cyano group, a nitro group, a substituted or unsubstituted alkyl group with 1 to 20 carbon atoms, a substituted or unsubstituted alkoxy group with 1 to 20 carbon atoms, a substituted or unsubstituted aryloxy group with 6 to 30 carbon atoms, a substituted or unsubstituted alkylthio group with 1 to 20 carbon atoms, a substituted or unsubstituted arylthio group with 6 to 30 carbon atoms, an substituted or unsubstituted arylalkyl group with 7 to 30 carbon atoms, an unsubstituted monocyclic group with 5 to 30 carbon atoms, a substituted or unsubstituted condensed polycyclic group with 10 to 30 carbon atoms or a substituted or unsubstituted heterocyclic group with 5 to 30 carbon atoms; Ar³ and Ar⁴ are independently a substituted or unsubstituted aryl group with 6 to 30 carbon atoms or a substituted or unsubstituted alkenyl group; and the substitutent is a substituted or unsubstituted alkyl group with 1 to 20 carbon atoms, a substituted or unsubstituted alkoxy group with 1 to 20 carbon atoms, a substituted or unsubstituted aryloxy group with 6 to 30 carbon atoms, a substituted or unsubstituted alkylthio group with 1 to 20 carbon atoms, a substituted or unsubstituted arylthio group with 6 to 30 carbon atoms, a substituted or unsubstituted arylalkyl group with 6 to 30 carbon atoms, an unsubstituted monocyclic group with 5 to 30 carbon atoms, a substituted or unsubstituted condensed polycyclic group with 10 to 30 carbon atoms, a substituted or unsubstituted heterocyclic group with 5 to 30 carbon atoms or a substituted or unsubstituted alkenyl group with 4 to 40 carbon atoms. 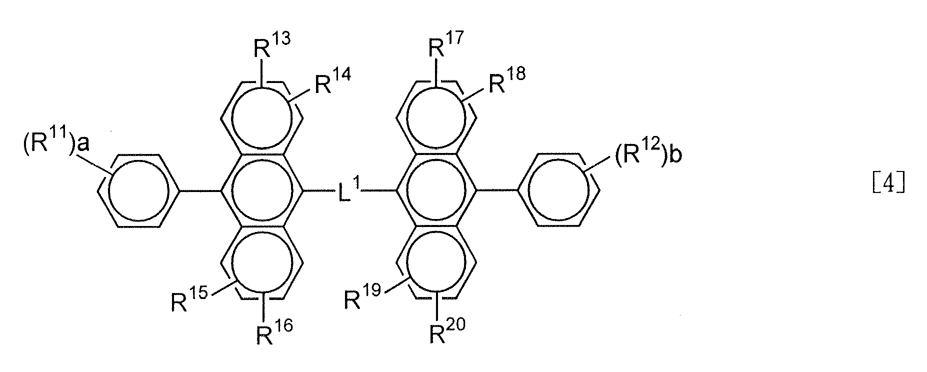 wherein R¹¹ to R²⁰ are independently a hydrogen atom, an alkenyl group, an alkyl group, a cycloalkyl group an aryl group, an alkoxy group, an aryloxy group, an alkylamino group, an arylamino group or a substitutable heterocyclic group; a and b are each an integer of 1 to 5; when they are 2 or more, R¹¹s or R¹²s may be the same as or different from each other, or R¹¹s or R¹²s may be bonded together to form a ring; R¹³ and R¹⁴, R¹⁵ and R¹⁶, R¹⁷ and R¹⁸, or R¹⁹ and R²⁰ may be bonded together to form a ring; and L¹ is a single bond, -O-, -S-, -N (R) - (R is an alkyl group or a substitutable aryl group) or an arylene group. 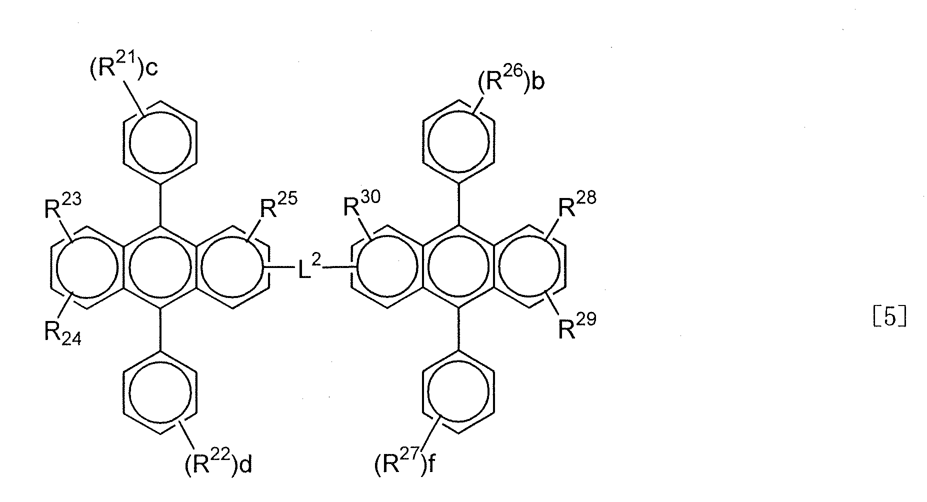 wherein R²¹ to R³⁰ are independently a hydrogen atom, an alkenyl group, an alkyl group, a cycloalkyl group an aryl group, an alkoxy group, an aryloxy group, an alkylamino group, an arylamino group or a substitutable heterocyclic group; c, d, e and f are each an integer of 1 to 5; when they are 2 or more, R²¹s, R²²s, R²⁶s or R²⁷s may be the same as or different from each other, R²¹s, R²²s, R²⁶s or R²⁷s may be bonded together to form a ring, or R²³ and R²⁴, or R²⁸ and R²⁹ may be bonded together to form a ring; and L² is a single bond, -O-, -S-, -N(R)-(R is an alkyl group or a substitutable aryl group) or an arylene group. 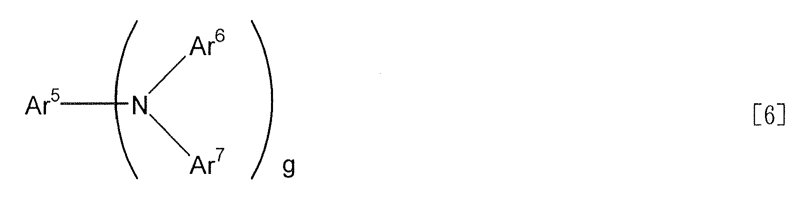 wherein Ar⁵, Ar⁶ and Ar⁷ are independently a substituted or unsubstituted monovalent aromatic group with 6 to 40 carbon atoms, at least one of them may include a styryl group and g is an integer of 1 to 4. 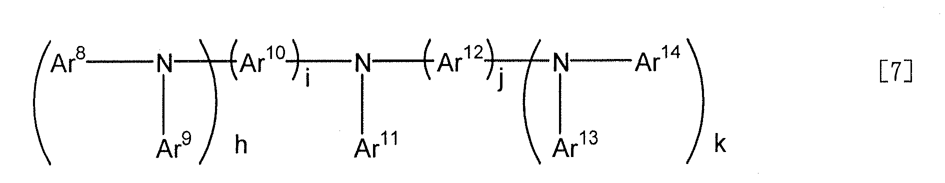 wherein Ar⁸, Ar⁹, Ar¹¹, Ar¹³ and Ar¹⁴ are independently a substituted or unsubstituted monovalent aromatic group with 6 to 40 carbon atoms, Ar¹⁰ and Ar¹² are independently a substituted or unsubstituted divalent aromatic group with 6 to 40 carbon atoms, at least one from Ar⁸ to Ar¹⁴ may include a styryl group or styrylene group, h and k are each an integer of 0 to 2 and i and j are each an integer of 0 to 3.

A blue dopant is preferably at least one selected from styrylamines, amine-substituted styryl compounds and compounds containing fused aromatic rings. A blue dopant may comprise multiple kinds of compounds.

Examples of the above-mentioned styryl amines and amine-substituted styryl compounds are compounds represented by the general formulas [8] to [9] and examples of the above-mentioned compounds containing fused aromatic rings are compounds represented by the general formula [10]. 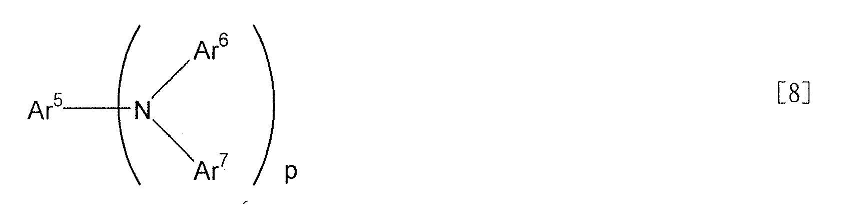 wherein Ar⁵, Ar⁹, and Ar⁷ are independently a substituted or unsubstituted aromatic group with 6 to 40 carbon atoms; at least one includes a styryl group therein and p is an integer of 1 to 3. 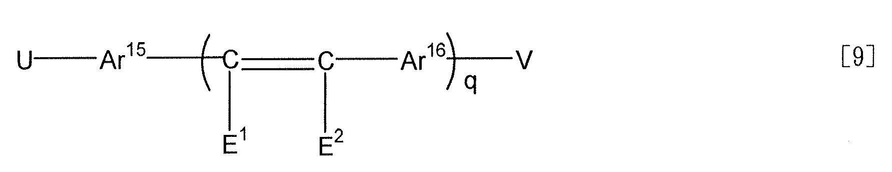 wherein Ar¹⁵ and Ar¹⁶ are independently an arylene group with 6 to 30 carbon atoms; E¹ and E² are independently an aryl or alkyl group with 6 to 30 carbon atoms, a hydrogen atom, or a cyano group; q is an integer of 1 to 3; U and/or V are a substituent including an amino group and the amino group is preferably an arylamino group. 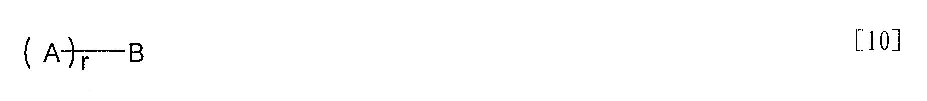 wherein A is an alkyl group or an alkoxy group with 1 to 16 carbon atoms, a substituted or unsubstituted aryl group with 6 to 30 carbon atoms, a substituted or unsubstituted alkylamino with 6 to 30 carbon atoms, a substituted or unsubstituted arylamino with 6 to 30 carbon atoms and B is a fused aromatic ring group with 10 to 40 carbon atoms; and r is an integer of 1 to 4.

### (2) Yellow-to-red emitting layer

A yellow-to-red emitting layer is composed of a host material and a yellow-to-red dopant.

A host material which is the same as that used for the blue emitting layer may be used. A different host material is preferably not used since the chromaticity greatly changes.

There can be used as a yellow-to-red dopant florescent compound containing at least one of a fluoranthene skeleton and a perylene skeleton. Examples include compounds represented by the following general formulas [11] to [27]. 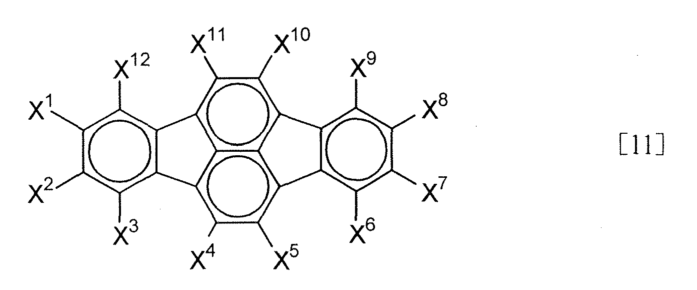 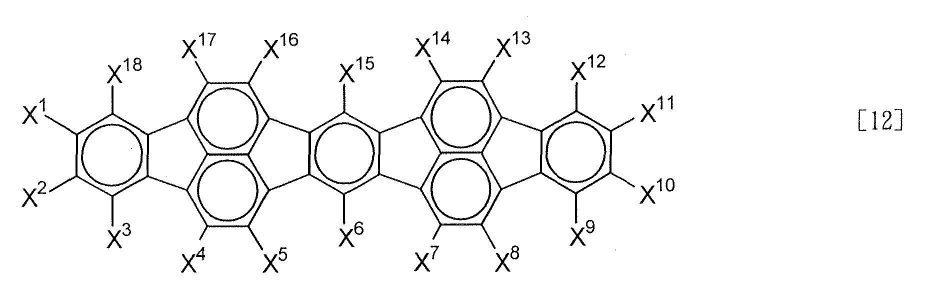 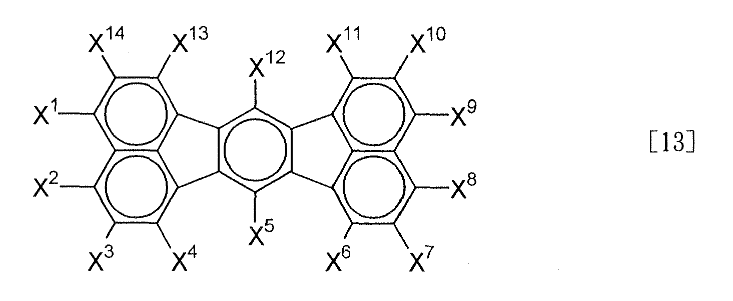 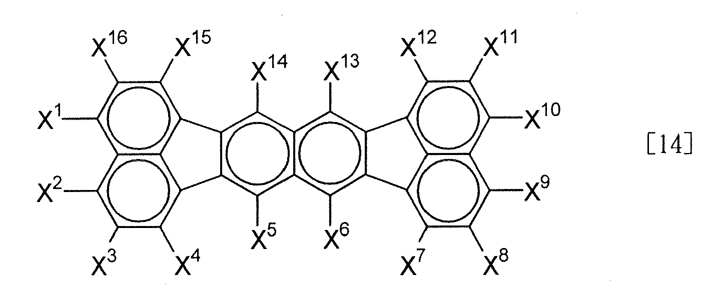 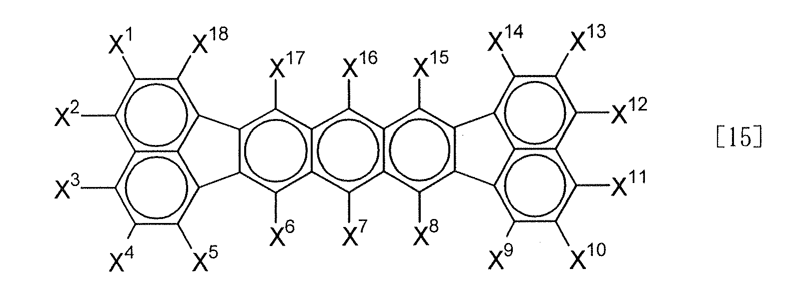 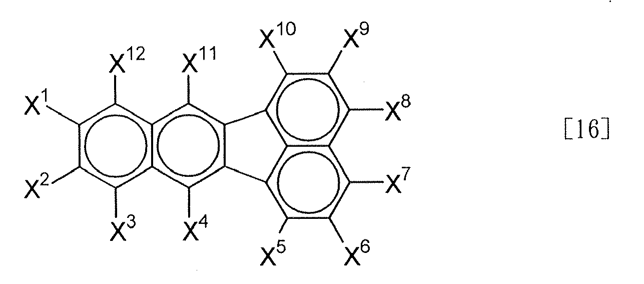 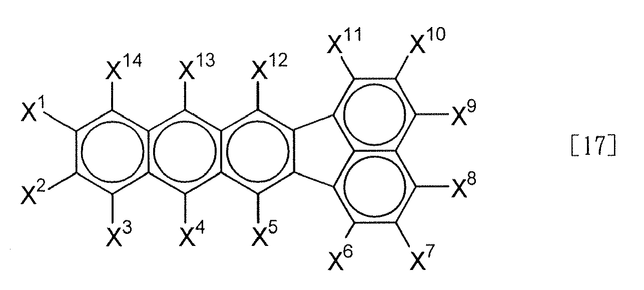 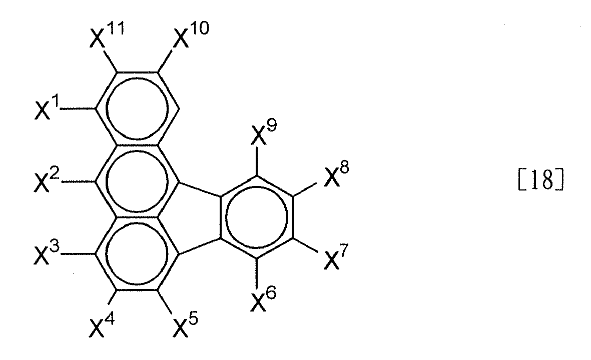 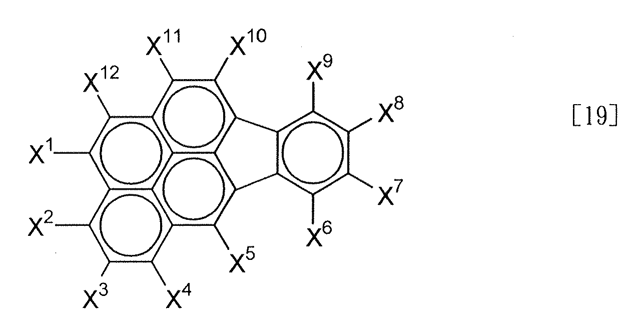 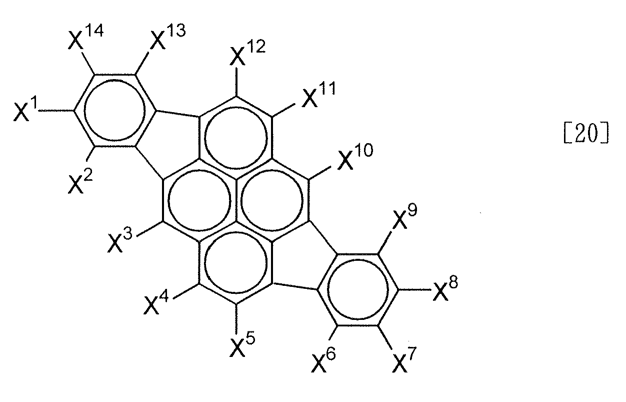 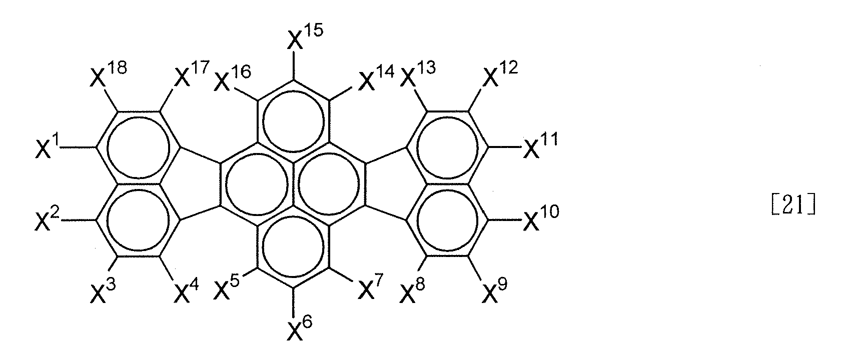 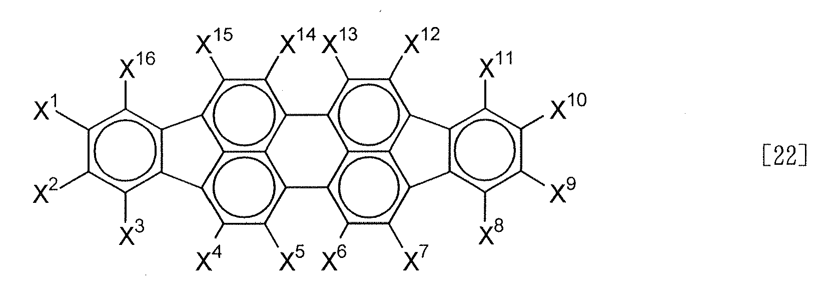 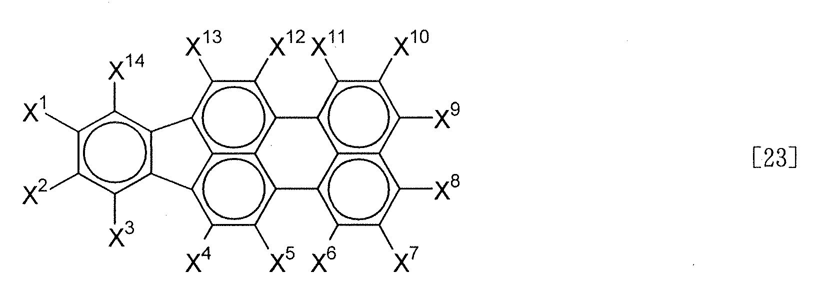 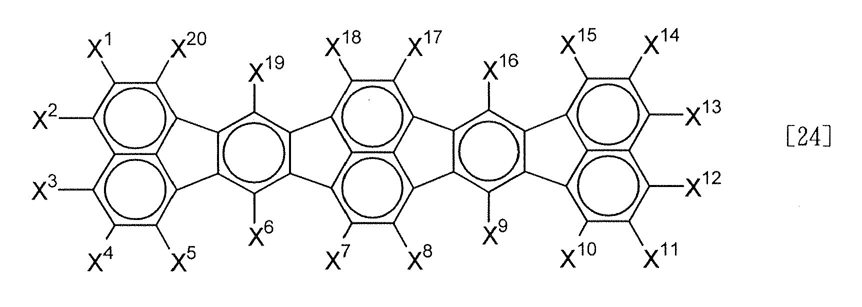 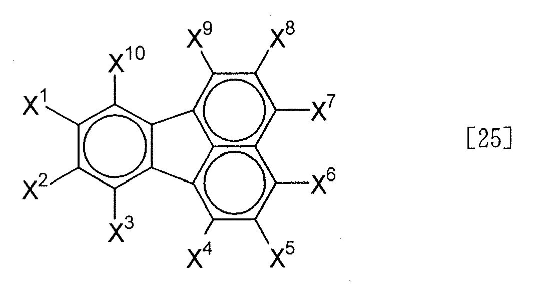 In the general formulas [11] to [25], X¹ to X²⁰ are independently a hydrogen atom, a linear, branched or cyclic alkyl group with 1 to 20 carbon atoms, a linear, branched or cyclic alkoxy group with 1 to 20 carbon atoms, a substituted or unsubstituted aryl group with 6 to 30 carbon atoms, a substituted or unsubstituted aryloxy group with 6 to 30 carbon atoms, a substituted or unsubstituted arylamino group with 6 to 30 carbon atoms, a substituted or unsubstituted alkylamino group with 1 to 30 carbon atoms, a substituted or unsubstituted arylalkylamino group with 7 to 30 carbon atoms or a substituted or unsubstituted alkenyl group with 8 to 30 carbon atoms; adjacent substituents and X¹ to X²⁰ may be bonded together to form a ring structure; and when adjacent substituents are an aryl group, the substituents may be the same.

The compounds represented by the general formulas [11] to [25] preferably contain an amino group or an alkenyl group. 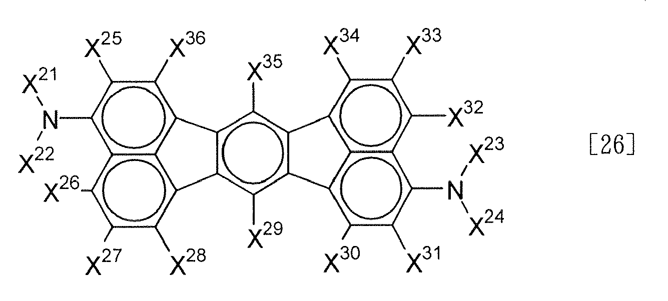 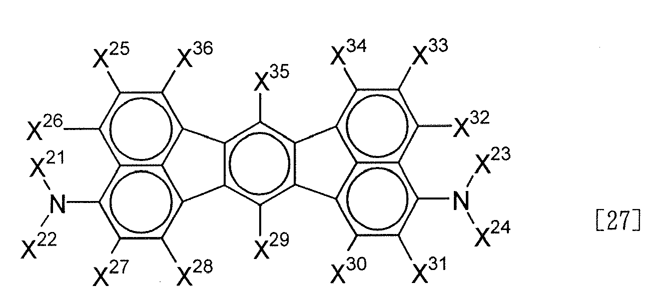 In the general formulas [26] to [27], wherein X²¹ to X²⁴ are independently an alkyl group with 1 to 20 carbon atoms, a substituted or unsubstituted aryl group with 6 to 30 carbon atoms; X²¹ and X²² and/or X²³ and X²⁴ may be bonded to each other with a carbon to carbon bond, -O- or -S- therebetween; X²⁵ to X³⁶ are a hydrogen atom, a linear, branched or cyclic alkyl group with 1 to 20 carbon atoms, a linear, branched or cyclic alkoxy group with 1 to 20 carbon atoms, a substituted or unsubstituted aryl group with 6 to 30 carbon atoms, a substituted or unsubstituted aryloxy group with 6 to 30 carbon atoms, a substituted or unsubstituted arylamino group with 6 to 30 carbon atoms, a substituted or unsubstituted alkylamino group with 1 to 30 carbon atoms, a substituted or unsubstituted arylalkylamino group with 7 to 30 carbon atoms or a substituted or unsubstituted alkenyl group with 8 to 30 carbon atoms; adjacent substituents and X²⁵ to X³⁶ may be bonded together to form a ring structure; and the substituents X²⁵ to X³⁶ in each of the formulas preferably contain an amine or alkenyl group.

A florescent compound containing a fluoranthene skeleton preferably contains an electron-donating group for high performance and long lifetime. A preferable electron-donating group is a substituted or unsubstituted arylamino group.

A fluorescent compound containing a fluoranthene skeleton preferably has 5 or more fused rings, more preferably 6 or more fused rings, for the following reason. The fluorescent compound has a fluorescent peak wavelength of 540 to 700 nm. The emission from a blue light emitting material and emission from the fluorescent compound overlap to give a white color.

The above-mentioned fluorescent compound preferably contains a plurality of fluoranthene skeletons since the emitted light falls in the yellow-to-red zone. Particularly preferred fluorescent compound contains an electron-donating group and a fluoranthene or perylene skeleton and has a fluorescent peak wavelength of 540 to 700 nm.

The thickness of the blue emitting layer is preferably 5 to 30 nm, more preferably 7 to 30 nm and most preferably 10 to 30 nm. When the thickness is less than 5 nm, it may be difficult to form the emission layer and to adjust the chromaticity. When the thickness is more than 30 nm, the driving voltage may increase.

The thickness of the yellow-to-red emitting layer is preferably 10 to 50 nm, more preferably 20 to 50 nm and most preferably 30 to 50 nm. When the thickness is less than 10 nm, the luminous efficiency may decrease. When the thickness exceeds 50 nm, the driving voltage may increase.

### 2. Other organic layers

### (1) First organic layer

A hole-injecting layer, a hole-transporting layer, an organic semiconductor layer and the like can be arranged between the anode and the blue emitting layer as a first organic layer.

The hole-injecting layer or the hole-transporting layer is a layer for helping the injection of holes into the emitting layer so as to transport holes to an emitting region. The hole mobility thereof is large and the ionization energy thereof is usually as small as 5.5 eV or less. A hole-injecting layer is formed to control energy level, for example, to reduce rapid energy level changes. Such a hole-injecting, transporting layer is preferably made of a material which can transport holes to the emitting layer at a low electric field intensity. The hole mobility thereof is preferably at least 10⁻⁶ cm²/V·second when an electric field of, e.g., 10⁴ to 10⁶ V/cm is applied.

The material for forming the hole-injecting layer or the hole-transporting layer is not particularly limited except for being required to have the above-mentioned preferred properties. The material can be arbitrarily selected from materials which have been widely used as a material transporting electric charge of holes in photoconductive materials and known materials used in a hole-injecting layer of organic EL devices.

As materials for a hole-injecting layer and a hole-transporting layer, specific examples thereof include triazole derivatives (see USP No. 3,112,197 and others), oxadiazole derivatives (see USP No. 3,189,447 and others), imidazole derivatives (see JP-B-37-16096 and others), polyarylalkane derivatives (see USP Nos. 3,615,402, 3,820,989 and 3,542,544, JP-B-45-555 and 51-10983, JP-A-51-93224, 55-17105, 56-4148, 55-108667, 55-156953 and 56-36656, and others), pyrazoline derivatives and pyrazolone derivatives (see USP Nos. 3, 180, 729 and 4, 278, 746, JP-A-55-88064, 55-88065, 49-105537, 55-51086, 56-80051, 56-88141, 57-45545, 54-112637 and 55-74546, and others), phenylene diamine derivatives (see USP No. 3,615,404, JP-B-51-10105, 46-3712 and 47-25336, JP-A-54-53435, 54-110536 and 54-119925, and others), arylamine derivatives (see USP Nos. 3,567,450, 3,180,703, 3,240,597, 3,658,520, 4,232,103, 4,175,961 and 4,012,376, JP-B-49-35702 and 39-27577, JP-A-55-144250, 56-119132 and 56-22437, DE1,110,518, and others), amino-substituted chalcone derivatives (see USP No. 3,526,501, and others), oxazole derivatives (ones disclosed in USP No. 3, 257, 203, and others), styrylanthracene derivatives (see JP-A-56-46234, and others), fluorenone derivatives (JP-A-54-110837, and others), hydrazone derivatives (see USP Nos. 3,717,462, JP-A-54-59143, 55-52063, 55-52064, 55-46760, 55-85495, 57-11350, 57-148749 and 2-311591, and others), stylbene derivatives (see JP-A-61-210363, 61-228451, 61-14642, 61-72255, 62-47646, 62-36674, 62-10652, 62-30255, 60-93455, 60-94462, 60-174749 and 60-175052, and others), silazane derivatives (USP No. 4,950,950), polysilanes (JP-A-2-204996), aniline copolymers (JP-A-2-282263), and electroconductive high molecular oligomers (in particular thiophene oligomers) disclosed in JP-A-1-211399.

The above-mentioned substances can be used as the material of the hole-injecting layer or the hole-transporting layer. The following can also be used: porphyrin compounds (disclosed in JP-A-63-2956965 and others), aromatic tertiary amine compounds and styrylamine compounds (see USP No. 4,127,412, JP-A-53-27033, 54-58445, 54-149634, 54-64299, 55-79450, 55-144250, 56-119132, 61-295558, 61-98353 and 63-295695, and others), in particular, the aromatic tertiary amine compounds. The following can also be given as examples: 4,4'-bis(N-(1-naphthyl)-N-phenylamino)biphenyl, which has in the molecule thereof two condensed aromatic rings, disclosed in USP No. 5,061,569, and
4,4',4"-tris(N-(3-methylphenyl)-N-phenylamino)triphenylamin e, wherein three triphenylamine units are linked to each other in a star-burst form, disclosed in JP-A-4-308688. Inorganic compounds such as aromatic dimethylidene type compounds, mentioned above as the material for an emitting layer, and p-type Si and p-type SiC can also be used as the material of the hole-injecting layer or the hole-transporting layer.

This hole-injecting layer or the hole-transporting layer may be a single layer made of one or more of the above-mentioned materials. Hole-injecting layers or the hole-transporting layers made of compounds different from each other may be stacked.

The thickness of the hole-injecting layer or the hole-transporting layer is not particularly limited, and is preferably from 20 to 200 nm.

The organic semiconductor layer is a layer for helping the injection of holes or electrons into the emitting layer, and is preferably a layer having an electroconductivity of 10⁻¹⁰ S/cm or more. The material of such an organic semiconductor layer may be an electroconductive oligomer, such as thiophene-containing oligomers or arylamine-containing oligomers disclosed in JP-A-8-193191, electroconductive dendrimers such as arylamine-containing dendrimers.

The thickness of the organic semiconductor layer is not particularly limited, and is preferably from 10 to 1,000 nm.

### (2) Second organic layer

An electron-injecting layer, an electron-transporting layer and the like can be arranged between a cathode and a yellow-to-red emitting layer as a second organic layer.

The electron-injecting layer or the electron-transporting layer is a layer for helping the injection of electrons into the emitting layer, and has a large electron mobility. The electron-injecting layer is formed to control energy level, for example, to reduce rapid energy level changes.

The material used in the electron-injecting layer is preferably a metal complex of 8-hydroxyquinoline or a derivative thereof. Specific examples of the metal complex include metal chelate oxynoid compounds containing a chelate of oxine (generally, 8-quinolinol or 8-hydroxyquinoline). For example, tris(8-quinolinol) aluminum can be used. Examples of the oxadiazole derivative include electron transporting compounds represented by the following general formulas [28] to [30]: 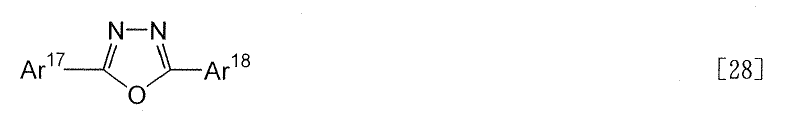 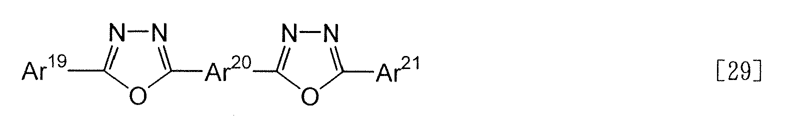 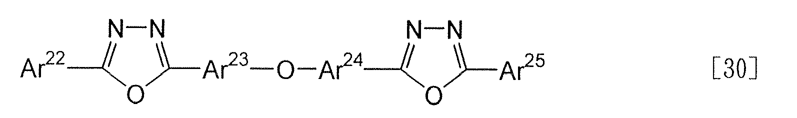 wherein Ar¹⁷, Ar¹⁸, Ar¹⁹, Ar²¹, Ar²² and Ar²⁵ each represent a substituted or unsubstituted aryl group; Ar¹⁷ and Ar¹⁸, Ar¹⁹ and Ar²¹, and Ar²² and Ar²⁵ may be the same as or different from each other; Ar²⁰, Ar²³ and Ar²⁴ each represent a substituted or unsubstituted arylene group; and Ar²³ and Ar²⁴ may be the same as or different from each other.

Examples of the aryl group in the general formulas [28] to [30] include phenyl, biphenyl, anthranyl, perylenyl, and pyrenyl groups. Examples of the arylene group include phenylene, naphthylene, biphenylene, anthranylene, perylenylene, and pyrenylene groups. Examples of the substituent include alkyl groups with 1 to 10 carbons, alkoxy groups with 1 to 10 carbons, and a cyano group. The electron transporting compounds are preferably ones from which a thin film can be easily formed. Specific examples of the electron transporting compounds are as follows.

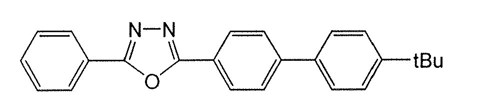

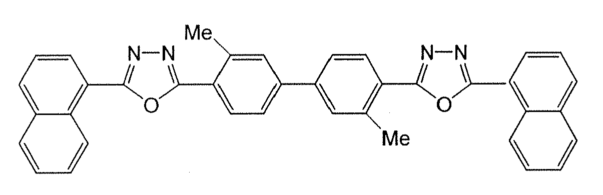

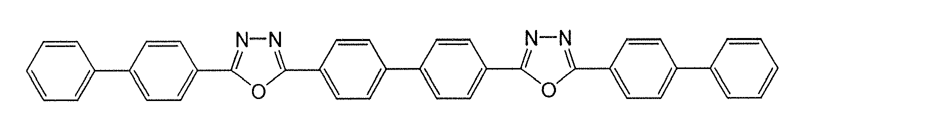

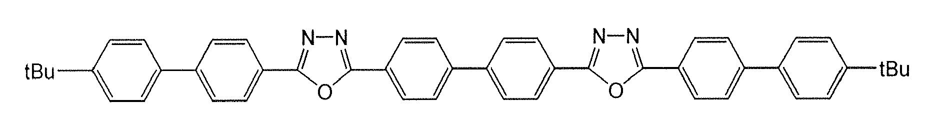

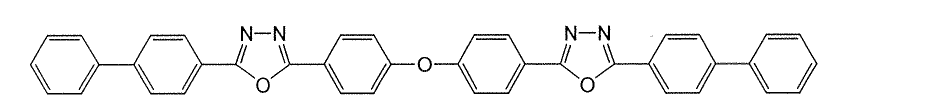

The thickness of the electron-injecting layer or the electron-transporting layer is not particularly limited, and is preferably from 1 to 100 nm.

A blue emitting layer or a first organic layer that is the organic layer closest to an anode preferably contains an oxidizer. A preferable oxidizer contained in the emitting layer or first organic layer is an electron-attracting compound or electron accepter.

Preferable oxidizers include Lewis acids, various quinone derivatives, dicyanoquinodimethan derivatives, and salts of an aromatic amine and a Lewis acid. Particularly preferable Lewis acids are iron chloride, antimony chloride, aluminum chloride and so on.

The yellow-to-red emitting layer or a second organic layer that is the organic layer closest to the cathode preferably contains a reducing agent. Preferable reducing agents include alkaline metals, alkaline earth metals, alkaline metal oxides, alkaline earth oxides, rare earth oxides, alkaline metal halides, alkaline earth halides, rare earth halides, and complexes of an alkaline metal and an aromatic compound. Particularly preferable alkaline metals are Cs, Li, Na, and K.

### 3. Inorganic compound layer

There may be provided an inorganic compound layer(s) in contact with an anode and/or a cathode. The inorganic compound layer functions as an adhesion improving layer.

Preferable inorganic compounds used for the inorganic compound layer include alkaline metal oxides, alkaline earth oxides, rare earth oxides, alkaline metal halides, alkaline earth halides, rare earth halides, and various oxides, nitrides and nitric oxides such as SiOₓ, AlOₓ, SiNₓ, SiON, AlON, GeOₓ, LiOₓ, LiON, TiOₓ, TiON, TaOₓ, TaON, TaNₓ and C.

As a component of layer in contact with an anode, SiOₓ, AlOₓ, Sinₓ, SiON, AlON, GeOₓ and C are preferable, since they can form a stable injecting interface layer.

As a component of layer in contact with a cathode, LiF, MgF₂, CaF₂, MgF₂ and NaF are preferable.

The thickness of the inorganic compound layer is not particularly limited, and is preferably from 0.1 nm to 100 nm.

Methods of forming various organic layers including an emitting layer and inorganic compound layer are not particularly limited. For example, known methods such as deposition, spin coating, casting, and LB technique can be applied. The electron-injecting layer and emitting layer are preferably formed by the same method, because this makes the properties of the organic EL devices obtained constant and the production time can be shortened. For example, when the electron-injecting layer is formed by deposition, the emitting layer also is preferably formed by deposition.

### 4. Electrodes

For the anode, the following is preferably used: metals, alloys or electric conductive compounds, or mixtures thereof that have a large work function (e. g. , 4 eV or more). Specific examples are indium tin oxide (ITO), indium zinc oxide, tin, zinc oxide, gold, platinum, and palladium. They can be used individually or as a combination of 2 or more kinds.

The thickness of the anode is not particularly limited, but is preferably from 10 to 1,000 nm, more preferably from 10 to 200 nm.

For the cathode, the following is preferably used: metals, alloys or electric conductive compounds, or a mixture thereof that have a small work function (e.g., less than 4 eV). Specific examples include magnesium, aluminum, indium, lithium, sodium, and silver. They can be used individually or as a combination of 2 or more kinds. The thickness of the cathode is not also particularly limited, but is preferably from 10 to 1,000 nm, more preferably from 10 to 200 nm.

It is preferred that at least one of the anode and the cathode be substantially translucent, more specifically, have a light transmission of 10% or more, in order to effectively take out light emitted from an emitting layer to the outside.

The electrodes can be formed by vacuum deposition, sputtering, ion plating, electron beam deposition, CVD, MOCVD, plasma CVD and so on.

Examples of the invention will be explained below, but the invention is not limited to the following examples.

Organic EL devices obtained in the examples were evaluated as follows.
(1) Initial performance: Chromaticity was measured and evaluated using CIE1931 chromaticity coordinate.
(2) Lifetime: Lifetime was evaluated by half-life of luminance and chromaticity change under constant current driving at an initial luminance of 1000 cd/m².
(3) Heat resistance: Heat resistance was evaluated by chromaticity change after a storage test for 500 hours at 105°C. L/J change is a change when the initial L/J ratio is 1.

### [Examples]

### Example 1

### (Fabrication of organic EL device)

A glass substrate measuring 25 mm by 75 mm by 1.1 mm with an ITO transparent electrode (GEOMATEC CO., LTD.) was subjected to ultrasonic cleaning with isopropyl alcohol for 5 minutes, and cleaned with ultraviolet rays and ozone for 30 minutes.

The resultant substrate was mounted on a substrate holder in a vacuum deposition device. First, a film of N,N'-bis(N,N'-diphenyl-4-aminophenyl)-N,N'-diphenyl-4,4'-di amino-1,1'-biphenyl (TPD232 film), having a thickness of 60 nm, was formed so as to cover the surface of the transparent electrode on which transparent electrode lines were formed. The TPD232 film functioned as a hole-injecting layer.

After forming the TPD232 film, a layer of 4,4'-bis[N-(1-naphthyl)-N-phenylamino]biphenyl film (NPD film), having a thickness of 20 nm, was formed on the TPD232 film. The NPD film functioned as a hole-transporting layer.

Further, after forming the NPD film, a styryl derivative DPVPDAN represented by formula [31] and B1 represented by formula [32] were deposited to a thickness of 10 nm at a weight ratio of 40:1 to form a blue emitting layer.

Next, the styryl derivative DPVPDAN and R1 (fluorescent peak wavelength: 545 nm) represented by formula [33] were deposited to a thickness of 30 nm at a weight ratio of 40:1 to form a yellow-to-red emitting layer.

A 10 nm thick tris(8- quinolinol) aluminum film (Alq film) was formed thereon.

Thereafter lithium (lithium source: SAES Getters) and Alq were co-deposited to form a 10 nm thick Alq:Li film as an electron-injecting layer. Metal Al was deposited on this Alq:Li film in a thickness of 150 nm to form a metallic cathode, thereby forming an organic EL device.

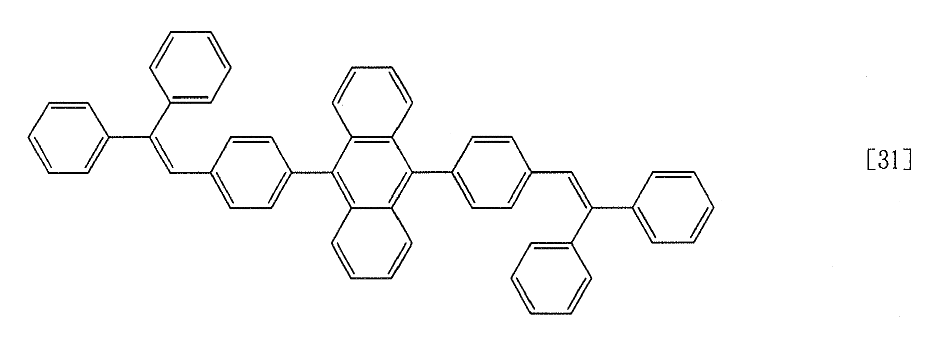

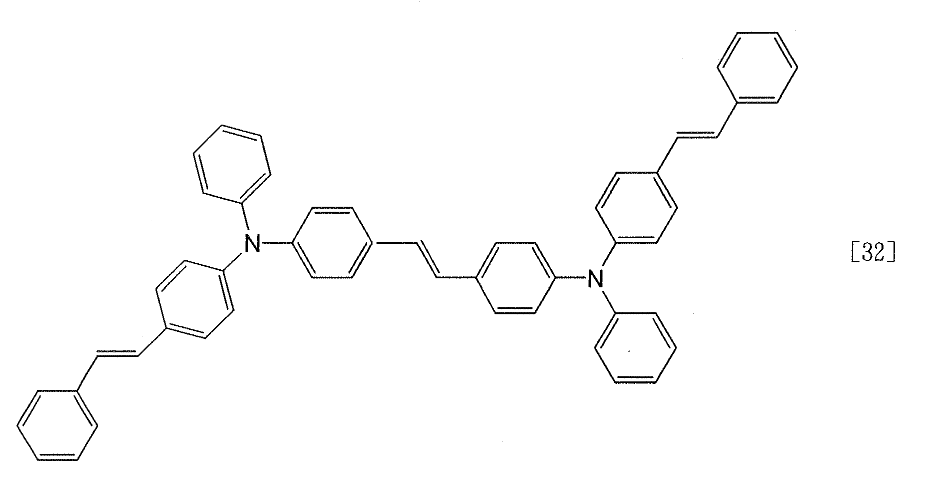

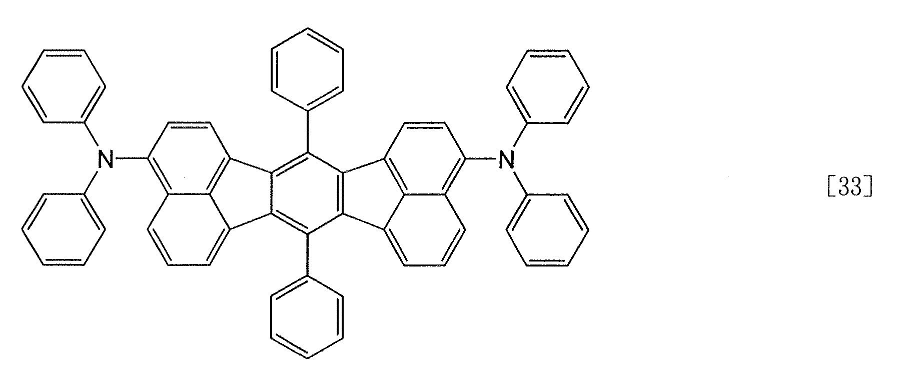

### (Performance evaluation of organic EL device)

This device emitted white light with a maximum luminance of 110 thousand cd/m², a luminance of 100 cd/m², and an efficiency of 7 cd/A at a voltage of 5 V. The light from this device had CIE1931 chromaticity coordinates of (x, y) = (0.282, 0.281), and we confirmed that it was white color.

The lifetime of the device was an excellent 10 thousand hours under constant current driving at an initial luminance of 1000 cd/m².

The chromaticity was (0.278, 0.271) after 500 hours in a storage test at 105 °C. The chromaticity difference between after and before the test was excellent (-0.004, -0.010).

Table 1 shows the measurement results on the initial performance, lifetime and heat resistance of the organic EL devices obtained in Example 1 and Comparative Examples 1 to 3 described later.

It is apparent from this table that the organic EL device of this example had a long lifetime, a high heat resistance and small chromaticity change.

### Comparative Example 1

A device was fabricated by the same method as in Example 1. However, on the NPD film, the styryl derivative DPVPDAN and compound (R1) were deposited to a thickness of 10 nm at a weight ratio of 100:1 to form a yellow-to-red emitting layer, and the styryl derivative DPVPDAN and compound (B1) were then deposited to a thickness of 30 nm at a weight ratio of 40: 1 to form a blue emitting layer. The device emitted light with a chromaticity of (0.417, 0.436), that is, yellow, not white. The result of a storage test at 105 °C was that the chromaticity change was much larger than in Example 1.

### Comparative Example 2

A device was fabricated by the same method as in Example 1. However, on the NPD film, the styryl derivative DPVPDAN and compounds (R1) were deposited to a thickness of 5 nm at a weight ratio of 300:1 to form a yellow-to-red emitting layer and the styryl derivative DPVPDAN and compounds (B1) were deposited to a thickness of 35 nm at a weight ratio of 40:1 to form a blue emitting layer. The device emitted light with a chromaticity of (0.321, 0.341), that is, good white. However, in a storage test at 105 °C, the chromaticity change was found to be larger than in Example 1.

### Comparative Example 3

A device was fabricated by the same method as in Example 1. However, as a hole-transporting layer, (R1) was doped with NPD at a ratio of NPD to R1 of 40 to 1. Only the blue emitting layer was formed in a thickness of 40 nm as an emitting layer.

**Table 1**

| | Initial performance | Continuous driving at room temperature | |
|---|---|---|---|
| | Chromaticity | Half-life (h) | Chromaticity change |
| Example 1 | (0.282,0.281) | 10000 | (0.015,0.015) |
| Comparative Example 1 | (0.417,0.436) | 7000 | (0.015,0.020) |
| Comparative Example 2 | (0.321,0.341) | 10000 | (0.015,0.015) |
| Comparative Example 3 | (0.330,0.345) | 8000 | (0.018,0.024) |

| | Heat resistance | |
|---|---|---|
| | L/J change | Chromaticity change |
| Example 1 | 1.17 | (-0.004,-0.010) |
| Comparative Example 1 | 1.44 | (0.024,0.034) |
| Comparative Example 2 | 1.20 | (0.012,0.019) |
| Comparative Example 3 | 1.20 | (0.025,0.036) |

### Industrial Utility

The invention provides a white organic EL device with reduced chromaticity changes.

## Claims

1. A white electroluminescent device comprising in sequence:
an anode,
a blue emitting layer containing a host material and a blue dopant,
a yellow-to-red emitting layer containing a host material identical to the host material of the blue emitting layer and a yellow-to-red dopant, and
a cathode,
the blue emitting layer and the yellow-to-red emitting layer forming an emitting layer.

2. A white electroluminescent device according to claim 1, wherein the blue emitting layer comprises an oxidizer.

3. A white electroluminescent device according to claim 1, further comprising a first organic layer between the anode and the blue emitting layer, the first organic layer comprising an oxidizer.

4. A white electroluminescent device according to claim 1, wherein the yellow-to-red emitting layer comprises a reducer.

5. A white electroluminescent device according to claim 1, further comprising a second organic layer between the cathode and the yellow-to-red emitting layer and the second organic layer comprises a reducer.

6. A white electroluminescent device according to claim 1, further comprising an inorganic compound layer contacting the anode and/or the cathode.

7. A white electroluminescent device according to claim 1, wherein the host material is a styryl derivative, an anthracene derivative or an aromatic amine.

8. A white electroluminescent device according to claim 7, wherein the styryl derivative is a di-styryl derivative, a tris-styryl derivative, a tetra-styryl derivative or a styryl amine derivative.

9. A white electroluminescent device according to claim 7, wherein the anthracene derivative is a compound containing a phenyl anthracene skeleton.

10. A white electroluminescent device according to claim 7, wherein the aromatic amine is a compound containing 2, 3 or 4 nitrogen atoms substituted with an aromatic group.

11. A white electroluminescent device according to claim 10, wherein the aromatic amine further contains at least one alkenyl group.

12. A white electroluminescent device according to claim 1, wherein the blue dopant is at least one compound selected from styryl amines, amine substituted styryl compounds and fused-aromatic-ring containing compounds.

13. A white electroluminescent device according to claim 1, wherein the yellow-to-red dopant is a compound containing a plurality of fluoranthene skeletons.

14. A white electroluminescent device according to claim 1, wherein the yellow-to-red dopant is a compound containing an electron-donating group and a fluoranthene skeleton.

15. A white electroluminescent device according to claim 1, wherein a fluorescence peak wavelength of the yellow-to-red dopant is 540 nm to 700 nm.

16. A white electroluminescent device according to claim 1, wherein the thickness of the blue emitting layer or the yellow-to-red emitting layer is 5 nm and more.
